# EUROPEAN PATENT APPLICATION

(11) **EP 2 579 326 A1**
(43) Date of publication of application: **10.04.2013**
(21) Application number: 11789813.0
(22) Date of filing: 31.05.2011
(51) Int. Cl.: H01L 31/04

(54) **CIGS SOLAR CELL AND SUBSTRATE FOR CIGS SOLAR CELL**

(30) Priority: 31.05.2010 JP 2010124976
(71) Applicant: Asahi Glass Company, Limited, Tokyo 100-8405 (JP)
(72) Inventor: MITSUI, Akira, Tokyo 100-8405 (JP); OKATO, Takeshi, Tokyo 100-8405 (JP); ODAKA, Hidefumi, Tokyo 100-8405 (JP); KAWAMOTO, Yasushi, Tokyo 100-8405 (JP)
(74) Representative: Ehlich, Hendrik
(86) International application number: PCT/JP2011/062512
(87) International publication number: WO 2011/152410

(57) **Abstract**

It is an object of the present invention to provide a CIGS type solar cell which has a common construction, which has a durability, wherein an alkali metal can be supplied to a CIGS layer.

A CIGS type solar cell comprising; an insulative supporting substrate; a rear surface electrode layer provided on the insulative supporting substrate; a CIGS layer provided on the rear surface electrode layer; a buffer layer provided on the CIGS layer; and a transparent front surface electrode layer provided on the buffer layer; the solar cell further comprising an alkali metal supply layer provided between the insulative supporting substrate and the rear surface electrode layer or provided between the rear surface electrode layer and the CIGS layer, or between the insulative supporting substrate and the rear surface electrode layer and between the rear surface electrode layer and the CIGS layer; and the alkali metal supply layer containing at least one compound selected from the group consisting of a LiNbO₃ compound, a NaNbO₃ compound and a KNbO₃ compound.

## Description

### TECHNICAL FIELD

The present invention relates to a CIGS type solar cell and a substrate constituting such a solar cell.

### BACKGROUND ART

A CIGS type solar cell shows a high energy conversion efficiency, and shows little deterioration of the efficiency due to light-irradiation. For this reason, research and development of such a solar cell is being conducted in various companies or research agencies.

A typical CIGS type solar cell is constituted by a substrate of e.g. a glass, and a Mo (molybdenum) electrode, a CIGS layer, a buffer layer and a ZnO (zinc oxide) electrode laminated in this order on the substrate.

In such a construction, the buffer layer functions as a n-type semiconductor layer and the CIGS layer functions as a p-type semiconductor layer. Accordingly, when the CIGS layer (pn junction) is irradiated with light, photoexcitation of electrons occurs to produce photovoltaic power. Accordingly, by light-irradiation of a solar cell, it is possible to take out a DC current from electrodes to the outside.

Here, the CIGS layer is usually composed of a compound such as Cu(In,Ga)Se₂. Further, it is known that in such a CIGS layer, due to the presence of an alkali metal such as Na (sodium), the defect density is low and the carrier density is high. In a case of employing a CIGS layer having a high carrier density, the energy conversion efficiency of a solar cell is improved.

Accordingly, it is proposed to provide a layer containing an alkali metal such as Na (sodium) between a Mo electrode and a CIGS layer (Patent Documents 1 and 2). In this case, during a process for producing a solar cell, it is possible to diffuse an alkali metal from a layer containing the alkali metal into the CIGS layer. Further, by this diffusion, it is possible to further improve the energy conversion efficiency of the solar cell.

### PRIOR ART DOCUMENTS

### PATENT DOCUMENTS

Patent Document 1: JP-A-2004-079858
Patent Document 2: JP-A-2004-140307

### DISCLOSURE OF INVENTION

### TECHNICAL PROBLEM

However, the layer containing an alkali metal described in the above document has such problems that it is hygroscopic and soluble to water, its handling is difficult and its durability is poor. For example, when Na₂S described in Patent Document 1 is used as an alkali metal supply layer, during the process for producing a solar cell, it is necessary to prepare an environment wherein contact with a moisture-containing atmosphere is shielded or an environment wherein the humidity is controlled. Further, in the process for producing a solar cell, it becomes impossible to clean a member with water or an aqueous solution at a time of removing foreign objects.

Thus, in the constructions described in Patent Documents 1 and 2, it is not practical to handle a substrate in such a manner that the substrate contacts with an environmental air.

Further, it is known to use a soda lime glass (it is abbreviated to as SLG) substrate as a supply source of alkali metal. However, since SLG has an alkali-metal content of only about 22 atomic% based on the total amount of other metallic cation elements, a supply source of alkali metal having a higher alkali metal content is desired.

The present invention has been made under the circumstances, and it is an object of the present invention to provide a CIGS type solar cell having a more practical construction wherein an alkali metal can be diffused in a CIGS layer. Further, it is also an object of the present invention to provide a substrate for a solar cell for constituting such a solar cell.

### SOLUTION TO PROBLEM

The present invention provides a CIGS type solar cell comprising;
an insulative supporting substrate;
a rear surface electrode layer provided on the insulative supporting substrate;
a CIGS layer provided on the rear surface electrode layer;
a buffer layer provided on the CIGS layer; and
a transparent front surface electrode layer provided on the buffer layer;
the solar cell further comprising an alkali metal supply layer provided between the insulative supporting substrate and the rear surface electrode layer or between the rear surface electrode layer and the CIGS layer, or provided between the insulative supporting substrate and the rear surface electrode layer and between the rear surface electrode layer and the CIGS layer; and
the alkali metal supply layer containing at least one compound selected from the group consisting of a NaNbO₃ compound and a KNbO₃ compound.

Further, the present invention provides a CIGS type solar cell comprising;
an insulative supporting substrate;
a rear surface electrode layer provided on the insulative supporting substrate;
a CIGS layer provided on the rear surface electrode layer;
a buffer layer provided on the CIGS layer; and
a transparent front surface electrode layer provided on the buffer layer;
the solar cell further comprising an alkali metal supply layer provided between the insulative supporting substrate and the rear surface electrode layer or between the rear surface electrode layer and the CIGS layer, or provided between the insulative supporting substrate and the rear surface electrode layer and between the rear surface electrode layer and the CIGS layer; and
the alkali metal supply layer containing at least one compound selected from the group consisting of a LiNbO₃ compound, a NaNbO₃ compound and a KNbO₃ compound.

Here, in the solar cell of the present invention, the alkali metal supply layer may have a thickness within a range of from 20 nm to 200 nm. The thickness may be more preferably within a range of from 20 nm to 100 nm.

Further, in the solar cell of the present invention, a substrate (in this specification, this substrate is referred to as an insulative supporting substrate) to be provided with the rear surface electrode layer, may be composed of an insulative substratum itself or composed of a conductive substratum provided with an insulative layer.

In this case, the insulative supporting substrate is preferably a glass substrate or a plastic substrate.

Further, the present invention provides a substrate for a CIGS type solar cell, which comprises an insulative supporting substrate, a rear surface electrode layer provided on a first surface of the insulative supporting substrate, and an alkali metal supply layer;
the alkali metal supply layer being provided between the first surface and the rear surface electrode layer or on the rear surface electrode layer or provided between the first surface and the rear surface electrode layer and on the rear surface electrode layer; and
the alkali metal supply layer containing at least one compound selected from the group consisting of a NaNbO₃ compound and a KNbO₃ compound.

Further, the present invention provides a substrate for a CIGS type solar cell, which comprises an insulative supporting substrate, a rear surface electrode layer provided on a first surface of the insulative supporting substrate, and an alkali metal supply layer;
the alkali metal supply layer being provided between the first surface and the rear surface electrode layer or on the rear surface electrode layer or provide between the first surface and the rear surface electrode layer and on the rear surface electrode layer; and
the alkali metal supply layer containing at least one compound selected from the group consisting of a LiNbO₃ compound, a NaNbO₃ compound and a KNbO₃ compound.

Here, in the substrate for a solar cell of the present invention, the alkali metal supply layer preferably has a thickness within a range of from 20 nm to 200 nm. More preferably, the thickness is within a range of from 20 nm to 100 nm.

Further, the substrate for a solar cell of the present invention may be composed of an insulative substratum itself or composed of an electrically conductive substratum provided with an insulative layer.

Further, the present invention provides a substrate for a CIGS type solar cell, which comprises an insulative supporting substrate and an alkali metal supply layer provided on a first surface of the insulative supporting substrate,
the alkali metal supply layer containing at least one compound selected from the group consisting of a NaNbO₃ compound and a KNbO₃ compound.

Further, the present invention provides a substrate for a CIGS type solar cell, which comprises an insulative supporting substrate and an alkali metal supply layer provided on a first surface of the insulative supporting substrate,
the alkali metal supply layer containing at least one compound selected from the group consisting of a LiNbO₃ compound, a NaNbO₃ compound and a KNbO₃ compound.

Here, in the substrate for a solar cell of the present invention, the alkali metal supply layer preferably has a thickness within a range of from 20 nm to 200 nm. The thickness is more preferably within a range of from 20 nm to 100 nm.

Further, the substrate for a solar cell of the present invention may be composed of an insulative substratum itself or composed of an electrically conductive substratum provided with an insulative layer.

### ADVANTAGEOUS EFFECTS OF INVENTION

The present invention can provide a CIGS type solar cell which has a more practical construction, wherein an alkali metal can be diffused in a CIGS layer without sacrificing water resistance, low hygroscopic property or low solubility to water and without sacrificing handling property in a production process of the solar cell. Further, the present invention can provide a substrate for a solar cell to produce such a solar cell.

### BRIEF DESCRIPTION OF DRAWINGS

Fig. 1 is a cross-sectional view schematically showing the construction of a conventional CIGS type solar cell.
Fig. 2 is a cross-sectional view schematically showing an example of the construction of a CIGS type solar cell of the present invention.
Fig. 3 is a graph showing measurement result of Na diffusion behavior obtained in samples.

### DESCRIPTION OF EMBODIMENTS

Now, the present invention will be described with reference to drawings.

First in order to make the characteristics of the present invention more easily understandable, the construction of a conventional CIGS type solar cell will be briefly described.

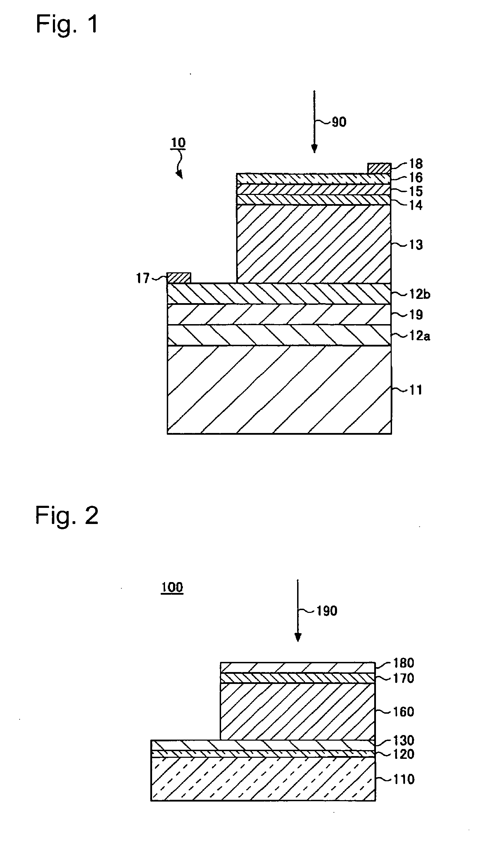

Fig. 1 schematically shows a cross-sectional view of an example of a conventional CIGS type solar cell.

As shown in Fig. 1, a conventional CIGS type solar cell 10 is constituted by an insulative supporting substrate 11, a first conductive layer 12a, a layer containing alkali metal (alkali metal supply layer) 19, a second conductive layer 12b, a light-absorber layer 13, a first semiconductor layer 14, a second semiconductor layer 15 and a transparent conductive layer 16, that are laminated in this order. Further, usually, the solar cell 10 has retrieving electrodes 17 and 18. Here, an arrow 90 indicates an incident direction of light into the solar cell 1.

The first conductive layer 12a and the second conductive layer 12b are each composed of Mo (molybdenum) and functions as a positive electrode of the solar cell 10. Meanwhile, the transparent conductive layer 16 is composed of e.g. ZnO (zinc oxide) and functions as a negative electrode of the solar cell 1.

The first semiconductor layer 14 and the second semiconductor layer 15 are called also as buffer layers, which have a function of forming a high resistance layer between the light-absorber layer 13 and the transparent conductive layer 16 to reduce a shuntpass of the solar cell.

The light-absorber layer 13 is usually composed of a compound such as Cu(In,Ga)Se₂. Here, since the light-absorber layer 13 is usually called also as a CIGS layer, hereinafter this layer is referred to as "CIGS layer 13".

The alkali metal supply layer 19 is provided to supply an alkali metal to the CIGS layer 13. The alkali metal supply layer 19 is, for example, composed of a compound such as Na₂S, Na₂Se, NaCl or NaF. It is known that in the presence of an alkali metal such as Na (sodium), the defect density reduces and the carrier density increases in the CIGS layer 13. Accordingly, when the alkali metal supply layer 19 is provided in the vicinity of the CIGS layer 13, an alkali metal moves from the alkali metal supply layer 19 to the CIGS layer 13, whereby the defect density decreases and the carrier density improves in the CIGS layer 13. Further, accordingly, the energy conversion efficiency of the solar cell 1 improves.

In such a construction of the solar cell 1, the buffer layers 14 and 15 function as n-type semiconductor layers, and the CIGS layer 13 functions as a p-type semiconductor layer. Accordingly, when light is incident into the CIGS layer 13 (pn junction), photoexcitation of electrons, occurs to produce photovoltaic power. Accordingly, by irradiating the solar cell 1 with light, it is possible to take out a DC current to the outside via the retrieving electrode 17 connected to the first conductive layer 12a and the second conductive layer 12b (that are positive electrodes) and the retrieving electrode 18 connected to the transparent conductive layer 16 (negative electrode).

However, in the CIGS type solar cell 1 having such a construction, the above compound constituting the alkali metal supply layer 4 has hygroscopic property or solubility to water. Accordingly, the conventional solar cell 1 has a problem that its handling is difficult at a time of producing the solar cell or that its durability is poor. For example, when the alkali metal supply layer 4 has Na₂S, in the process for producing the solar cell, it is necessary to prepare an environment wherein contact with an atmosphere containing moisture is shielded or an environment wherein the humidity is controlled. Further, in the process for producing the solar cell, at a time of removing foreign objects, it is not possible to carry out water rinse or cleaning of the member with water or an aqueous solution. Accordingly, handing of the substrate in such a manner that the substrate contacts with the air is not practical, and such a construction is not a practical construction to achieve a solar cell having a high durability.

On the other hand, as described in detail below, the solar cell of the present invention has characteristics that it is not necessary to carry out a special handling and e.g. water rinse is possible, and that the above problem of durability is effectively controlled.

Now, the construction of the CIGS type solar cell of the present invention will be described in detail with reference to drawings.

Fig. 2 schematically shows a cross-sectional view of an example of a CIGS type solar cell 100 of the present invention.

As shown in Fig. 2, the CIGS type solar cell 100 of the present invention is constituted by an insulative supporting substrate 110, an alkali metal supply layer 120, a rear surface electrode layer 130, a CIGS layer 160, a buffer layer 170 and a transparent front surface electrode layer 180, that are laminated in this order. Here, although not shown in the figure, besides the above components, the solar cell 100 usually has retrieving portions such as the retrieving electrodes 17 and 18 shown in Fig. 1 electrically connected with the electrode layers. An arrow 190 shows incident direction of light into the CIGS type solar cell 100.

The insulative supporting substrate 110 has a function of supporting layers laminated thereon.

The alkali metal supply layer 120 functions as a supply source for supplying an alkali metal such as Na (sodium), K (potassium) or Li (lithium) into the CIGS layer 160.

The rear surface electrode layer 130 and the transparent front surface electrode layer 180 function as electrodes for retrieving an electricity generated in the CIGS layer 160 by light irradiation, to the outside.

Here, as the CIGS layer 160 and the buffer layer 170, ones made of various types of known materials, and having known characteristics and functions used in a CIGS type solar cell may be employed.

Here, the alkali metal supply layer 120 of the solar cell 100 of the present invention has a characteristic that it contains at least one compound selected from the group consisting of a NaNbO₃ compound, a KNbO₃ compound and a LiNbO₃ compound.

The NaNbO₃ compound, the KNbO₃ compound and the LiNbO₃ compound are oxides stable in the air and have a characteristic that they are hardly soluble to water.

Accordingly, by constituting the alkali metal supply layer 120 so as to have such a compound, it is possible to efficiently suppress the above problem of difficulty of handling at a time of producing the solar cell 10 and reduction of its durability due to the hygroscopic property of the alkali metal supply layer 19 and its solubility to water. Further, in the process for producing a solar cell, it is possible to overcome the problem that water rinse or cleaning of a member with water or an aqueous solution cannot be used for removing foreign objects.

Further, since the solar cell 100 of the present invention has an alkali metal supply layer 120 containing the above compound, it is possible to supply an alkali metal to the CIGS layer 160. In the CIGS layer 160 to which the alkali metal is supplied, the defect density decreases and the carrier density increases. Accordingly, it is expected that a high energy conversion efficiency can be obtained in the solar cell 100 of the present invention.

Here, in Fig. 2, the alkali metal supply layer 120 is provided between the insulative supporting substrate 110 and the rear surface electrode layer 130. However, the construction of the present invention is not limited thereto. For example, the alkali metal supply layer 120 may be provided between the rear surface electrode layer 130 and the CIGS layer 160. Further, as the case requires, two alkali metal supply layers 120 may be provided between the insulative suprorting substrate 110 and the rear surface electrode layer 130 and between the rear surface electrode 130 and the CIGS layer 160, respectively.

### (Constituent members)

Now, e.g. the specifications of the constituent layers and constituent members of the CIGS type solar cell 100 of the present invention will be described in detail.

### (Insulative supporting substrate 110)

The insulative supporting substrate 110 may be composed of any material so long as it has a function of supporting members laminated on the substrate. Further, the shape of the insulative supporting substrate is not necessarily a flat plate shape, but it may be a curved shape or a tubular shape. So long as the insulative supporting substrate has a surface on which lamination of layers is possible, the shape of the insulative supporting substrate may be any shape. The shape is more preferably a flat plate shape or a curved plate shape having a first surface and a second surface opposite from the first surface.

The insulative supporting substrate is preferably composed of an insulative material itself such as a glass or polyimide. In a case of glass, the composition is not particularly limited, and the glass may be of a phosphate type or a silica type. In the case of silica type glass, the insulative supporting substrate 110 may, for example, have a composition containing, as calculated as oxides, from 60 mol% to 80 mol% of SiO₂, from 0.5 mol% to 7 mol% of Al₂O₃, from 3 mol% to 10 mol% of MgO, from 6 mol% to 9 mol% of CaO, from 0 to 5 mol% of SrO, from 0 to 4 mol% of BaO, from 0 to 2 mol% of ZrO₂, from 4 mol% to 13 mol% of Na₂O and from 0.1 mol% to 7 mol% of K₂O.

Further, since the solar cell 100 of the present invention has an alkali metal supply layer 120, the insulative supporting substrate may be composed of a material containing little alkali metal such as alkali free glass. Here, an alkali free glass means a glass wherein the total of Li₂O+Na₂O+K₂O as calculated as oxides is at most 0.1 mass%.

As such an alkali free glass, for example, one containing as calculated as mass percentage of oxides from 50 to 66% of SiO₂, from 10.5 to 22% of Al₂O₃, from 0 to 12% of B₂O₃, from 0 to 8% of MgO, from 0 to 14.5% of CaO, from 0 to 24% of SrO and from 0 to 13.5% of BaO, wherein MgO+CaO+SrO+BaO is from 9 to 29.5 mass%, is employed.

As an alternative, the insulative supporting substrate 110 may be composed of an electrically conductive material having a surface provided with an insulative layer. The electrically conductive material may be a metal such as a stainless steel or an aluminum alloy. Further, the insulative layer may be e.g. an oxide.

The thickness of the insulative supporting substrate 110 is, for example, within a range of from 0.5 mm to 6 mm.

### (Alkali metal supply layer 120)

The alkali metal supply layer 120 is composed of a niobium oxide containing an alkali metal. The alkali metal supply layer 120 is, for example, preferably composed of at least one compound selected from the group consisting of a LiNbO₃ compound, a NaNbO₃ compound and a KNbO₃ compound. Further, at least one compound selected from the group consisting of a LiNbO₃ compound, a NaNbO₃ compound and a KNbO₃ compound has a high alkali metal content of 50 atomic% based on the total amount of other metal cation elements. Further, among the LiNbO₃ compound, the NaNbO₃ compound and the KNbO₃ compound, the NaNbO₃ compound is particularly preferred since it has the highest melting point and it can be sintered at a higher sintering temperature as compared with the LiNbO₃ compound and the KNbO₃ compound, and accordingly, a sintered sputtering target having a high density to be employed for film-forming can be easily produced.

Further, the alkali metal supply layer 120 may contain other components within a degree not impairing the object and the effect of the present invention. The alkali metal supply layer 120 may contain elements other than Li (lithium), Na (sodium), K (potassium), Nb (niobium) and O (oxygen) within a range of at most 20 mass% based on the total mass.

Such a compound has no hygroscopic property and extremely low solubility to water, and thus, stable.

The thickness of the alkali metal supply layer 120 is, for example, within a range of from 20 nm to 200 nm. Particularly, the thickness of the alkali metal supply layer 120 is preferably within a range of from 20 nm to 100 nm. When the thickness is within such a range, it is possible to obtain good adhesiveness between the alkali metal supply layer 120 and the rear surface electrode layer 130 or between the rear surface electrode layer 130 and the CIGS layer 160.

### (Rear surface electrode layer 130)

The rear surface electrode layer 130 is, for example, composed of Mo (molybdenum), Ti (titanium), Al (aluminum) or Cr (chromium), etc.

The thickness of the rear surface electrode layer 130 is, for example, within a range of from 100 nm to 1,000 nm (preferably from 300 nm to 700 nm, for example, 500 nm). When the thickness of the rear surface electrode layer 130 increases, the adhesiveness with the substrate 110 or the adhesiveness with the alkali supply layer may decrease. Further, when the thickness of the rear surface electrode layer 13 becomes too small, the electric resistance of the electrode becomes large.

The method for forming the rear surface electrode layer 130 is not particularly limited. The rear surface electrode layer 130 can be formed on the insulative supporting substrate 110, for example, by a sputtering method, a vapor deposition method, a gas phase film-deposition method (PVD, CVD), etc.

### (CIGS layer 160)

The CIGS layer 160 is composed of a compound containing a Group Ib element, a Group IIIb element and a Group VIb element of the Periodic Table.

The CIGS layer 160 is, for example, composed of a semiconductor having a crystal structure such as chalcopyrite. In this case, the CIGS layer 160 can contain at least one element M selected from the group consisting of Cu (copper), In (indium) and Ga (gallium) and at least one element A selected from the group consisting of Se (selenium) and S (sulfur). For example, as the CIGS layer 160, CuInSe₂, CuIn(Se,S)₂, Cu(In,Ga)Se₂, Cu(In,Ga)(Se,S)₂, etc. may be employed. Further, the CIGS layer 160 may be composed of a semiconductor having a crystal structure similar to chalcopyrite.

The thickness of the CIGS layer 160 is not particularly limited, and for example, it is within a range of from 1,000 nm to 3,000 nm.

### (Buffer layer 170)

The buffer layer 170 is, for example, composed of a compound containing Cd (cadmium) or Zn (zinc) forming a semiconductor layer. The compound containing Cd may be e.g. CdS (cadmium sulfate), and the compound containing Zn may be ZnO (zinc oxide), ZnS (zinc sulfate), ZnMgO (zinc magnesium oxide), etc.

Further, the buffer layer 170 may be composed of a plurality of semiconductor layers as shown in the construction shown in Fig. 1. In this case, the first layer present closely to the CIGS layer 160 is composed of CdS or a compound containing Zn described above, and the second layer present distantly from the CIGS layer 160 is composed of e.g. ZnO (zinc oxide) or a material containing ZnO.

The thickness of the buffer layer 170 is not particularly limited, and it is, for example, within a range of from 50 nm to 300 nm.

### (Transparent front surface electrode layer 180)

The transparent front surface electrode layer 180 is, for example, composed of a material such as ZnO (zinc oxide) or ITO (indium tin oxide). As an alternative, the layer may be composed of any of these materials doped with a Group III element such as Al (aluminum). Further, the transparent front surface electrode layer 180 may be composed of a plurality of laminated layers.

The thickness of the transparent front surface electrode layer 180 (total thickness when it is constituted by a plurality of layers) is not particularly limited, and it is, for example, within a range of from 100 nm to 3,000 nm.

Here, the transparent front surface electrode layer 180 may be electrically connected with a conductive retrieving member. Such a retrieving member is, for example, preferably composed of at least one type of metal selected from the group consisting of Ni (nickel), Cr (chromium), Al (aluminum) and Ag (silver).

The solar cell of the present invention has a characteristic that it has, on a surface of an insulative supporting substrate, an alkali supply layer, a rear surface electrode layer, a CIGS layer, a buffer layer and a transparent front surface electrode layer; or on a surface of an insulative supporting substrate, a rear surface electrode layer, an alkali supply layer, a CIGS layer, a buffer layer and a transparent front surface electrode layer; or on a surface of an insulative supporting substrate, an alkali supply layer, a rear surface electrode layer, an alkali supply layer, a CIGS layer, a buffer layer and a transparent front surface electrode layer.

Further, the substrate for a solar cell of the present invention is characterized by having, on a surface of the insulative supporting substrate, an alkali supply layer and a rear surface electrode layer; or on an insulative supporting substrate, a rear surface electrode layer and an alkali supply layer; or on an insulative supporting substrate, an alkali supply layer, a rear surface electrode layer and an alkali supply layer. Further, the substrate for a solar cell of the present invention is characterized by having, on a surface of an insulative supporting substrate, an alkali supply layer.

However, in the solar cell or the substrate for a solar cell of the present invention, between the above layers or between the surface of the insulative supporting substrate and the layers formed thereon, an additional layer may be formed as the case requires in order to improve durability, adhesiveness, electrical characteristic, power generation efficiency, etc.

### EXAMPLES

Now, Examples of the present invention will be described.

By the following method, on a glass substrate, a NaNbO₃ layer as an alkali supply layer and a Mo layer as a rear surface electrode layer were deposited in this order to prepare test samples. Further, by using these test samples, the following properties were evaluated.

### (Preparation of test sample)

First, a glass substrate was prepared. The size of the glass substrate was 50 mm high × 50 mm wide × 1.1 mm thick. The composition of the glass substrate was, as calculated as oxides, 7.2 mol% of SiO₂, 1.1 mol% of Al₂O₃, 5.5 mol% of MgO, 8.6 mol% of CaO, 12.6 mol% of Na₂O and 0.2 mol% of K₂O.

Next, on the glass substrate, a NaNbO₃ layer was formed by a sputtering method.

As a sputtering apparatus, a magnetron RF sputtering apparatus (SPF210H, manufactured by Anelva Corporation) was employed. By using a NaNbO₃ sintered target, a NaNbO₃ layer was formed on the glass substrate. Further, the NaNbO₃ sintered target employed in this step was prepared by employing a Na₂CO₃ powder (special grade manufactured by Kanto Chemical) and a Nb₂O₅ powder (3N grade manufactured by Koujundo Chemical Laboratory), and subjecting the powders to blending, preliminary baking, wet pulverization, formation and sintering (in the air of 1,330°C for 2 hours). Here, it was confirmed by a fluorescent X-ray method that the employed NaNbO₃ sintered target contains 0.01 mass% of K (potassium) as calculated as K₂O based on the total mass.

A mixed gas of argon and oxygen was used as a film-forming atmosphere. The concentration of oxygen in the mixed gas is 3 vol%. Further, the sputtering pressure was set to be 1.3 Pa, and the film-forming temperature (substrate temperature) was set to be a room temperature.

The thickness of the NaNbO₃ layer was set to be 20 nm, 50 nm, 100 nm, 200 nm or 500 nm (test samples No. 1 to No. 5, respectively).

Next, on the NaNbO₃ layer of each sample, a Mo layer was formed.

For the formation of Mo layer, a magnetron DC sputtering apparatus (SPL-71 1 V, manufactured by Tokki Corporation) was employed. As a target, a Mo target was employed. Argon was used as a film-forming atmosphere and the sputtering pressure was set to be 1.3 Pa. Further, the film-forming temperature (substrate temperature) was set to be a room temperature. The thickness of the Mo layer was set to be about 500 nm in all samples.

Besides the above samples, as a Comparative Example, a test sample having a Mo layer (500 nm) directly formed on a surface of a glass substrate without having a NaNbO₃ layer, was prepared (this is referred to as test sample No. 6).

Table 1 shows the layer structure and the thickness of NaNbO₃ in each test sample.

**[Table 1]**

| Sample | Thickness of NaNbO₃ layer (nm) | Evaluation results (1) of adhesiveness | Evaluation results (2) of adhesiveness |
|---|---|---|---|
| No. 1 | 20 | ○ | ○ |
| No. 2 | 50 | ○ | ○ |
| No. 3 | 100 | ○ | ○ |
| No. 4 | 200 | × | ○ |
| No. 5 | 500 | × | × |
| No. 6 | - | ○ | × |

### (Evaluation of characteristics)

With respect to each test sample (No. 1 to No. 6) obtained in the above step, measurement of Na diffusion behavior and adhesiveness test of Mo layer were carried out.

### (Measurement of Na diffusion behavior)

With respect to samples No. 1 to No. 4 and sample No. 6, measurement of Na diffusion behavior was carried out.

First, with respect to each sample, an ITO (indium tin oxide) film having a thickness of about 300 nm was formed on the Mo layer by a sputtering method to prepare an evaluation sample.

Here, the ITO film was formed by employing the above magnetron DC sputtering apparatus. As a target, an ITO target doped with 10 mass% of SnO₂ was employed. Further, as a sputtering gas, a mixed gas of argon and oxygen (oxygen 1 vol%) was employed. The sputtering pressure was set to be 0.4 Pa. The film-forming temperature (substrate temperature) was set to be a room temperature.

Next, this evaluation sample was put in a nitrogen atmosphere and maintained at 550°C for 30 minutes to diffuse Na in the glass substrate into the ITO film.

Next, by employing a SIMS (Secondary Ion Mass Spectroscopy) apparatus (ADEPT1010 manufactured by Ulvac-Phi incorporated), the ITO film of the evaluation sample was dry-etched from the outermost surface side, and Na amount detected at this time was measured. As primary ions, O₂⁺ ions were employed. Further, the acceleration voltage was set to be 3 kV, and the beam current was set to be 200 nA. The cluster size was 300 µm × 300 µm. The etching rate was set to be about 1 nm/sec.

Measurement was carried out with respect to two portions of each evaluation sample.

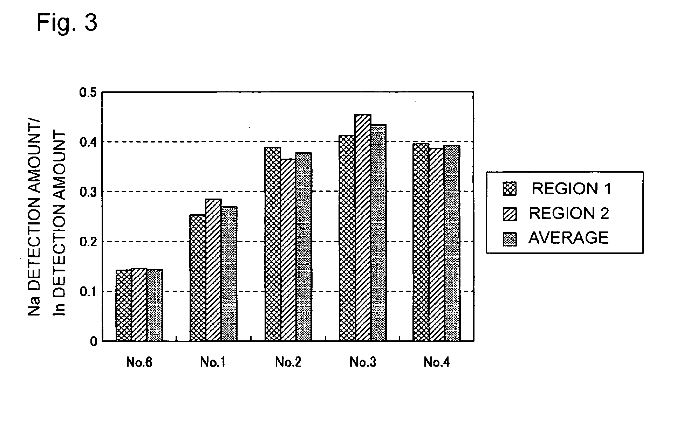

Fig. 3 shows results of evaluation samples. In Fig. 3, the horizontal axis represents sample No. (No. 1 to No. 4 and No. 6) (that corresponds to the thickness of NaNbO₃ layer) and the vertical axis represents the detection amount of Na measured in the evaluation. Here, the detection amount of Na shown in the vertical axis indicates the ratio of a count number of detected Na (sodium) based on detected In (indium) (that is an indium count number).

It is understandable from Fig. 3 that by changing the thickness of NaNbO₃ layer, Na diffusion amount can be changed. Namely, in the construction of the present invention, by changing the thickness of NaNbO₃ layer, it is considered to be possible to relatively easily control Na amount diffused in the CIGS layer.

### (Adhesiveness test of Mo layer)

Next, by employing test samples No.1 to No. 6, the adhesiveness of Mo layer was relatively evaluated by the following method.

First, each test sample was maintained (1) in a nitrogen atmosphere of 550°C for 10 minutes or (2) in an atmospheric air adjusted to be 50°C with a relative humidity of 50% for 24 hours. Next, on the Mo layer, an adhesive tape (CT-24 manufactured by Nichiban Co., Ltd.) and peeled to evaluate whether peeling of Mo layer occurred or not.

Columns of "Evaluation result (1) of adhesiveness" and "Evaluation result (2) of adhesiveness" of Table 1 show respective evaluation results of the above conditions. In Table 1, "○" indicates a case where no peeling of Mo layer occurred by the test, and "×" indicates a case where peeling of Mo layer occurred by the test.

It is understandable from these results that in the moisture resistance evaluation of the evaluation result (2) of adhesiveness, when the thickness of the NaNbO₃ layer is from 20 nm to 200 nm, no peeling of Mo layer occurred and the film showed a high moisture resistance, and improvement of moisture resistance was confirmed. Further, it was understood that in the moisture resistance evaluation of the evaluation results (1) of adhesiveness, when the thickness of the NaNbO₃ layer is at most 100 nm, no peeling of Mo layer occurred, and from the evaluation results (1) and (2) of adhesiveness, when the thickness of the NaNbO₃ layer was within a range of from 20 nm to 100 nm (test samples No. 1 to No. 3), an extremely good adhesiveness was obtained between the NaNbO₃ layer and the Mo layer.

### INDUSTRIAL APPLICABILITY

With the present invention, it is possible to provide a substrate for a solar cell, which is excellent in water resistance, low hygroscopic property and little solubility to water, wherein alkali metal can be diffused in the CIGS layer to increase carrier density and thereby to improve energy conversion efficiency of a solar cell. And by employing such a substrate, it is possible to obtain e.g. a CIGS type solar cell having an improved energy conversion efficiency. Accordingly, the present invention is useful.

The entire disclosure of Japanese Patent Application No. 2010-124976 filed on May 31, 2010 including specification, claims, drawings and summary is incorporated herein by reference in its entirety.

### REFERENCE SYMBOLS

- 10:: Conventional CIGS type solar cell
- 11:: Insulative supporting substrate
- 12a:: First conductive layer
- 12b:: Second conductive layer
- 13:: Light-absorber layer
- 14:: First semiconductor layer
- 15:: Second semiconductor layer
- 16:: Transparent conductive layer
- 17, 18:: Retrieving electrode
- 19:: Alkali metal supply layer
- 90:: Incident direction of light
- 100:: CIGS type solar cell of the present invention
- 110:: Insulative supporting substrate
- 120:: Alkali metal supply layer
- 130:: Rear surface electrode layer
- 160:: CIGS layer
- 170:: Buffer layer
- 180:: Transparent front surface electrode layer
- 190:: Incident direction of light

## Claims

1. A CIGS type solar cell comprising;
an insulative supporting substrate;
a rear surface electrode layer provided on the insulative supporting substrate;
a CIGS layer provided on the rear surface electrode layer;
a buffer layer provided on the CIGS layer; and
a transparent front surface electrode layer provided on the buffer layer;
the solar cell further comprising an alkali metal supply layer provided between the insulative supporting substrate and the rear surface electrode layer or between the rear surface electrode layer and the CIGS layer, or provided between the insulative supporting substrate and the rear surface electrode layer and between the rear surface electrode layer and the CIGS layer; and
the alkali metal supply layer containing at least one compound selected from the group consisting of a NaNbO₃ compound and a KNbO₃ compound.

2. A CIGS type solar cell comprising;
an insulative supporting substrate;
a rear surface electrode layer provided on the insulative supporting substrate;
a CIGS layer provided on the rear surface electrode layer;
a buffer layer provided on the CIGS layer; and
a transparent front surface electrode layer provided on the buffer layer;
the solar cell further comprising an alkali metal supply layer provided between the insulative supporting substrate and the rear surface electrode layer or between the rear surface electrode layer and the CIGS layer, or provided between the insulative supporting substrate and the rear surface electrode layer and between the rear surface electrode layer and the CIGS layer; and
the alkali metal supply layer containing at least one compound selected from the group consisting of a LiNbO₃ compound, a NaNbO₃ compound and a KNbO₃ compound.

3. The solar cell according to Claim 1 or 2, wherein the alkali metal supply layer has a thickness within a range of from 20 nm to 200 nm.

4. The solar cell according to any one of Claims 1 to 3, wherein the insulative supporting substrate is composed of an insulative substratum itself or composed of an electrically conductive substratum provided with an insulative layer.

5. The solar cell according to any one of Claims 1 to 4, wherein the insulative supporting substrate is a glass substrate or a plastic substrate.

6. A substrate for a CIGS type solar cell, which comprises an insulative supporting substrate, a rear surface electrode layer provided on a first surface of the insulative supporting substrate, and an alkali metal supply layer;
the alkali metal supply layer being provided between the first surface and the rear surface electrode layer or on the rear surface electrode layer or provided between the first surface and the rear surface electrode layer and on the rear surface electrode layer; and
the alkali metal supply layer containing at least one compound selected from the group consisting of a NaNbO₃ compound and a KNbO₃ compound.

7. A substrate for a CIGS type solar cell, which comprises an insulative supporting substrate, a rear surface electrode layer provided on a first surface of the insulative supporting substrate, and an alkali metal supply layer;
the alkali metal supply layer being provided between the first surface and the rear surface electrode layer or on the rear surface electrode layer or provide between the first surface and the rear surface electrode layer and on the rear surface electrode layer; and
the alkali metal supply layer containing at least one compound selected from the group consisting of a LiNbO₃ compound, a NaNbO₃ compound and a KNbO₃ compound.

8. The substrate for a CIGS type solar cell according to Claim 6 or 7, wherein the alkali metal supply layer has a thickness within a range of from 20 nm to 200 nm.

9. The substrate for a CIGS type solar cell according to any one of Claims 6 to 8, wherein the insulative supporting substrate is composed of an insulative substratum itself or an electrically conductive substratum provided with an insulative layer.

10. A substrate for a CIGS type solar cell, which comprises an insulative supporting substrate and an alkali metal supply layer provided on a first surface of the insulative supporting substrate,
the alkali metal supply layer containing at least one compound selected from the group consisting of a NaNbO₃ compound and a KNbO₃ compound.

11. A substrate for a CIGS type solar cell, which comprises an insulative supporting substrate and an alkali metal supply layer provided on a first surface of the insulative supporting substrate,
the alkali metal supply layer containing at least one compound selected from the group consisting of a LiNbO₃ compound, a NaNbO₃ compound and a KNbO₃ compound.

12. The substrate for a CIGS type solar cell according to Claim 10 or 11, wherein the alkali metal supply layer has a thickness within a range of from 20 nm to 200 nm.

13. The substrate for a CIGS type solar cell according to any one of Claims 10 to 12, wherein the insulative supporting substrate is composed of an insulative substratum itself or an electrically conductive substratum provided with an insulative layer.
